# EUROPÄISCHE PATENTSCHRIFT

(11) **EP 1 475 886 B1**
(45) Veröffentlichungstag und Bekanntmachung des Hinweises auf die Patenterteilung: **20.12.2006**
(21) Anmeldenummer: 03010197.6
(22) Anmeldetag: 06.05.2003
(51) Int. Cl.: H03F 3/217

(54) **Vorrichtung zum Einstellen einer Resonanzschaltung für eine minimale Leistungsaufnahme eines Verstärkers**
Apparatus having resonant circuit adjustable for minimum power consumption of an amplifier
Dispositif avec circuit résonant ajustable pour obtenir la puissance absorbée minimale d'un amplificateur

(43) Veröffentlichungstag der Anmeldung: 10.11.2004
(73) Patentinhaber: Fraunhofer-Gesellschaft zur Förderung der angewandten Forschung e.V., 80686 München (DE)
(72) Erfinder: Hedtke, Michael, 59174 Kamen (DE); Vom Bögel, Gerd, 42489 Wülfrath (DE); Hommels, Jörg, 47551 Bedburg-Hau (DE); Würsig, Holger, 47225 Duisburg (DE)
(74) Vertreter: Schoppe, Fritz

(56) Entgegenhaltungen:
- EP-A- 0 529 901
- US-A- 3 919 656
- US-B1- 6 232 841
- CANTRELL W H: "Circuit to aid tuning of Class-E amplifier" MICROWAVE SYMPOSIUM DIGEST. 2000 IEEE MTT-S INTERNATIONAL BOSTON, MA, USA 11-16 JUNE 2000, PISCATAWAY, NJ, USA,IEEE, US, 11. Juni 2000 (2000-06-11), Seiten 787-790, XP010507455 ISBN: 0-7803-5687-X
- COLLINS D ET AL: "COMPUTER CONTROL OF A CLASS-E AMPLIFIER" INTERNATIONAL JOURNAL OF ELECTRONICS, TAYLOR AND FRANCIS.LTD. LONDON, GB, Bd. 64, Nr. 3, 1. März 1988 (1988-03-01), Seiten 493-506, XP000049654 ISSN: 0020-7217
- KAZIMIERCZUK M K ET AL: "CLASS-E AMPLIFIER WITH AN INDUCTIVE IMPEDANCE INVERTER" IEEE TRANSACTIONS ON INDUSTRIAL ELECTRONICS, IEEE INC. NEW YORK, US, Bd. 37, Nr. 2, 1. April 1990 (1990-04-01), Seiten 160-166, XP000115744 ISSN: 0278-0046

## Beschreibung

Die vorliegende Erfindung bezieht sich auf ein Verfahren und eine Vorrichtung zum Einstellen einer Konfiguration einer Resonanzschaltung für eine minimale Leistungsaufnahme eines Verstärkers, der ein aktives Bauelement und die Resonanzschaltung umfaßt. Insbesondere bezieht sich die vorliegende Erfindung auf einen Klasse-E-Verstärker.

Klasse-E-Verstärker (N. O. Sokal, A. D. Sokal: "Class-E A New Class of High-Efficiency Tuned Single-Ended Switching Power Amplifiers", IEEE Journal of Solid-State Circuits, S. 168 - 176, Bd. SC-10, Nr. 3, Juni 1975) haben seit ihrer Erfindung eine weite Verbreitung gefunden. Sie weisen zahlreiche Vorteile auf, zu denen ihre Einfachheit, ihr hoher Wirkungsgrad und ihre gute Entwerfbarkeit zählen. Sie sind häufig bei Hochfrequenzanwendungen und bei Anwendungen mit Batteriebetrieb anzutreffen, bei denen ein niedriger Leistungsbedarf und ein hoher Wirkungsgrad wichtig sind.

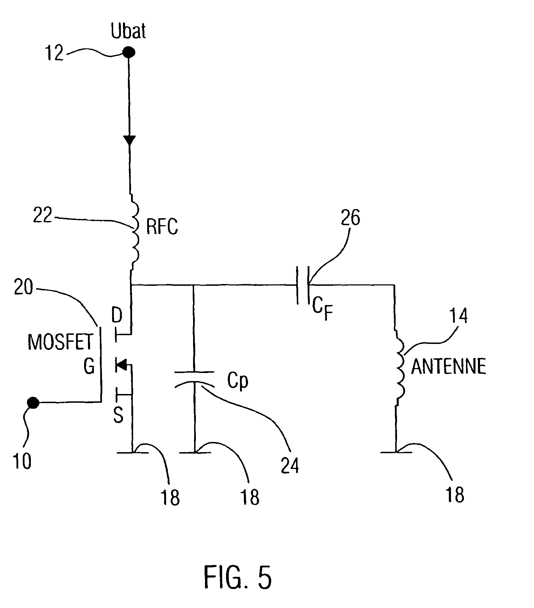

Fig. 5 ist ein schematisches Schaltungsdiagramm, das ein Beispiel für einen herkömmlichen Klasse-E-Verstärker zeigt. Der Verstärker weist einen Signaleingang 10, einen Versorgungsleistungseingang 12 und eine Antenne 14 als Signalausgang auf. Ein Ende der Antenne 14 ist mit Masse 18 verbunden. Am Versorgungsleistungseingang 12 liegt eine Versorgungsspannung Ubat gegenüber Masse 18 an. Der Signaleingang 10 ist mit einem Gate G eines MOSFET 20 verbunden. Die Source S des MOSFET 20 ist mit Masse 18 verbunden. Die Drain D des MOSFET 20 ist über eine Drossel bzw. eine Hochfrequenzdrossel (RFC; RFC = radio frequency choke) 22 mit dem Versorgungsleistungseingang 12 verbunden. Parallel zum Kanal des MOSFET 20 zwischen dessen Drain D und dessen Source S ist ein Parallelkondensator 24 mit der Kapazität Cp geschaltet, d. h. eine der Elektroden des Parallelkondensators 24 ist mit Masse 18 verbunden und die andere Elektrode des Parallelkondensators 24 ist mit der Drain D des MOSFET 20 und der Drossel 22 verbunden. Ferner umfaßt der Klasse-E-Verstärker einen Filterkondensator 26 mit der Kapazität C_{F}. Eine Elektrode des Filterkondensators 26 ist ebenfalls mit der Drain D des MOSFET 20 und der Drossel 22 verbunden, die andere Elektrode des Filterkondensators 26 ist über die Antenne 14 mit Masse 18 verbunden.

Am Signaleingang 10 des MOSFET 20 wird ein periodisches Eingangssignal mit einer Signalfrequenz angelegt. In der Regel weist das Eingangssignal zumindest näherungsweise eine Rechteckform auf. Aufgrund der Rechteckform des Eingangssignals am Signaleingang 10 und am Gate G des MOSFET 20 wird der MOSFET 20 im wesentlichen binär zwischen zwei Zuständen hin- und hergeschaltet. Während einer ersten Hälfte jeder Periode des Eingangssignals weist der Kanal des MOSFET 20 zwischen der Drain D und der Source S einen sehr hohen elektrischen Widerstand auf. Während der zweiten Hälfte jeder Periode des Eingangssignals weist der Kanal einen sehr kleinen Widerstand auf. Während der ersten Hälfte jeder Periode des Eingangssignals fließt ein näherungsweise verschwindender Strom durch den Kanal des MOSFET 20. Während der zweiten Hälfte jeder Periode des Eingangssignals fällt eine näherungsweise verschwindende Spannung am Kanal des MOSFET 20 ab. Die im MOSFET 20 bzw. seinem Kanal dissipierte Leistung ist deshalb in beiden Schaltzuständen des MOSFET 20 sehr klein bzw. näherungsweise Null. Dies begründet eine geringe Verlustleistung und einen hohen Wirkungsgrad des Klasse-E-Verstärkers.

In der Realität weicht das am Signaleingang 10 und am Gate G des MOSFET 20 anliegende Eingangssignal von der idealisierten Rechteckform ab. Deshalb und aufgrund seiner eigenen parasitären Kapazitäten, vor allem der endlichen Kapazität zwischen dem Gate G und dem Kanal, geht der MOSFET 20 nicht beliebig schnell, sondern innerhalb einer endlichen Zeit von dem Zustand des sehr kleinen Kanalwiderstands zu dem Zustand des sehr großen Kanalwiderstands und umgekehrt über. Während des Schaltens bzw. während dieses Übergangs weist der Kanal des MOSFET 20 einen endlichen Widerstand auf. Es wird deshalb Leistung im MOSFET 20 bzw. in dessen Kanal dissipiert, wenn im Moment des Schaltens eine Spannung zwischen der Drain D und der Source S des MOSFET 20 anliegt und ein Strom durch den Kanal des MOSFET 20 fließt.

Um den Wirkungsgrad des Klasse-E-Verstärkers zu optimieren bzw. zu maximieren, werden die Kapazität C_{F} des Filterkondensators 26, die Induktivität der Antenne 14, die Kapazität Cₚ des Parallelkondensators 24 und die Induktivität der Drossel 22 so dimensioniert, daß eine Resonanzfrequenz bei der Signalfrequenz des am Signaleingang 10 anliegenden Eingangssignals vorliegt. Etwas vereinfacht können in diesem Zusammenhang der Filterkondensator 26 und die Antenne 14 als Reihenschwingkreis angesehen werden, deren Bauelementparameter die Resonanzfrequenz bzw. den Resonanzpunkt des Verstärkers bestimmen. Tatsächlich haben jedoch auch die Induktivität der Drossel 22 und die Kapazität Cₚ des Parallelkondensators 24 Einfluß auf die Lage der Resonanzfrequenz.

Wenn der Klasse-E-Verstärker im Resonanzpunkt arbeitet, folgt die Spannung zwischen der Drain D des MOSFET 20 und der Masse 18 während der ersten Hälfte jeder Periode des Eingangssignals näherungsweise einer Sinusfunktion mit der Signalfrequenz, wobei die Knoten am Beginn und am Ende der ersten Hälfte der Periode liegen. In der zweiten Hälfte der Periode ist die Spannung zwischen der Drain D des MOSFET 20 und der Masse 18 Null. Der Strom durch den Kanal des MOSFET 20 ist in der ersten Hälfte jeder Periode Null. In der zweiten Hälfte jeder Periode folgt er näherungsweise einer Sinusfunktion mit der Signalfrequenz, wobei die Knoten am Beginn und am Ende der zweiten Hälfte der Periode liegen. Auf diese Weise ist die Bedingung für einen optimalen Wirkungsgrad gegeben, daß Strom und Spannung über den Kanal des MOSFET 20 jeweils im Moment des Umschaltens zwischen dem Zustand sehr kleinen Widerstands und dem Zustand sehr großen Widerstands verschwinden.

Die beschriebene Dimensionierung bzw. Abstimmung der Drossel 22, des Parallelkondensators 24 und insbesondere der Antenne 14 und des Filterkondensators 26 wird durch Bauelementstreuungen bzw. durch in der Realität unvermeidliche Abweichungen realer Bauelementgrößen von deren Sollwerten verfälscht bzw. verschlechtert. In der Realität arbeitet der in der Fig. 5 dargestellt Klasse-E-Verstärker deshalb bestenfalls näherungsweise in seinem Resonanzpunkt. Die Effizient bzw. der Wirkungsgrad des Klasse-E-Verstärkers ist deshalb nicht optimal, und sein Leistungsbedarf ist höher als im Fall einer idealen Abstimmung.

Ferner ist es für viele Anwendungen erwünscht oder erforderlich, die von dem Klasse-E-Verstärker verarbeitete Signalfrequenz innerhalb eines endlichen Frequenzintervalls durchzustimmen. Es ist offensichtlich, daß der Klasse-E-Verstärker und insbesondere die Antenne 14 und der Filterkondensator 26 in diesem Fall nur für eine einzige Signalfrequenz ideal abgestimmt sein können und für alle anderen Signalfrequenzen innerhalb des Frequenzintervalls ein nichtoptimaler Wirkungsgrad vorliegt.

Auch Verstärker anderer Klassen bzw. Typen weisen oft eine Resonanzschaltung bzw. Bauelemente, die einen Resonanzpunkt des Verstärkers bestimmen, auf, wobei der Versorgungsleistungsbedarf des Verstärkers von der Abstimmung des Resonanzpunktes auf die Signalfrequenz eines verarbeiteten Signals abhängt.

Das US Patent 6232841 und die Artikel "Computer Control of a Class-E Amplifier", von D. Collins et al (Intl. J. of Electronics 1988) und "Circuit to Aid Tuning of Class-E Amplifier", von W. H. Cantrell (IEEE 2000) offenbaren Klasse E Verstärker mit Vorrichtungen zur Abstimmung der Resonanzfrequenz.

Die Aufgabe der vorliegenden Erfindung besteht darin, ein Verfahren zur Einstellung einer minimalen Leistungsaufnahme eines Verstärkers und einen Verstärker mit einer minimalen Leistungsaufnahme zu schaffen.

Diese Aufgabe wird durch einen Verstärker gemäß Anspruch 1 gelöst.

Die vorliegende Erfindung schafft einen Verstärker mit einem aktiven Bauelement, einer Resonanzschaltung mit einer Mehrzahl von einstellbaren Konfigurationen, einer Einstelleinrichtung zum Einstellen von einer der Mehrzahl von Konfigurationen der Resonanzschaltung, einer Meßeinrichtung zum Messen einer Versorgungsleistungsaufnahme des Verstärkers und einer Steuereinrichtung. Die Steuereinrichtung ist ausgebildet, um die Einstelleinrichtung derart zu steuern und die Meßeinrichtung derart auszulesen, daß die Einstelleinrichtung nacheinander eine Mehrzahl von Konfigurationen einstellt und die Meßeinrichtung für jede der Mehrzahl von Konfigurationen die Versorgungsleistungsaufnahme des Verstärkers mißt. Die Steuereinrichtung ist ferner ausgebildet, um eine optimale Konfiguration aus der Mehrzahl von Konfigurationen zu bestimmen, bei der die Versorgungsleistungsaufnahme minimal ist, und um die Einstelleinrichtung zu steuern, um die Resonanzschaltung gemäß der optimalen Konfiguration einzustellen.

Die vorliegende Erfindung beruht auf der Idee, in einem Verstärker eine Resonanzschaltung mit einer Mehrzahl von Konfigurationen vorzusehen, wobei eine Versorgungsleistungsaufnahme des Verstärkers von der eingestellten Konfiguration der Resonanzschaltung abhängt. Die verschiedenen Konfigurationen der Resonanzschaltung werden nacheinander automatisch eingestellt, wobei bei jeder Konfiguration die Versorgungsleistungsaufnahme des Verstärkers gemessen wird. Die optimale Konfiguration, bei der die Versorgungsleistungsaufnahme des Verstärkers minimal ist, wird bestimmt und eingestellt.

Ein Vorteil der vorliegenden Erfindung besteht darin, daß sie eine minimale Versorgungsleistungsaufnahme und einen maximalen Wirkungsgrad eines Verstärkers schafft. Sie ist insbesondere für Verstärker geeignet, deren Bauelementparameter herstellungsbedingten Unsicherheiten und Schwankungen unterliegen und nicht ohne weiteres oder nicht mit vertretbarem Aufwand genau festgelegt werden können. Ferner ist die vorliegende Erfindung für Verstärker geeignet, die nicht nur für eine einzige Signalfrequenz, sondern für eine Signalfrequenz innerhalb eines endlichen Frequenzintervalls vorgesehen sind. In beiden Fällen schafft die vorliegende Erfindung eine minimale Versorgungsleistungsaufnahme bzw. einen maximalen Wirkungsgrad des Verstärkers. Die vorliegende Erfindung eignet sich besonders für Anwendungen, bei denen eine Minimierung der Versorgungsleistungsaufnahme wichtig ist, beispielsweise für mobile Geräte, die aus Batterien oder Akkumulatoren mit elektrischer Leistung versorgt werden.

Gemäß einem bevorzugten Ausführungsbeispiel der vorliegenden Erfindung handelt es sich bei dem Verstärker um einen Klasse-E-Verstärker, dessen aktives Bauelement einen ersten Anschluß, einen zweiten Anschluß und einen Steueranschluß umfaßt, wobei die Resonanzschaltung mit dem zweiten Anschlüssen verbunden ist, an dem die Versorgungsleistung anliegt.

Die Resonanzschaltung umfaßt vorzugsweise ein Kapazitätsbauelement mit einer Kapazität und ein Induktivitätsbauelement mit einer Induktivität, wobei bei verschiedenen Konfigurationen der Resonanzschaltung verschiedene Kapazitäten des Kapazitätsbauelements oder verschiedene Induktivitäten des Induktivitätsbauelements eingestellt sind. Gemäß einem bevorzugten Ausführungsbeispiel umfaßt das Kapazitätsbauelement eine Kondensatordekade, deren Gesamtkapazität durch Parallelschalten einer Mehrzahl von Kondensatoren einstellbar ist.

Induktivitätsbauelemente mit einstellbarer Induktivität und vor allem Kapazitätsbauelemente mit einstellbarer Kapazität, insbesondere Kondensatordekaden, sind einfach und mit geringem Aufwand herstellbar und ermöglichen damit eine besonders kostengünstige Implementierung der vorliegenden Erfindung. Wie die nachfolgenden Ausführungsbeispiele zeigen werden, ist die vorliegende Erfindung ferner mit wenigen einfachen digitalen Elementen implementierbar. Das Verfahren ist einfach und robust und bietet eine zuverlässige Minimierung der Versorgungsleistungsaufnahme.

Bevorzugte Weiterbildungen sind in den Unteransprüchen definiert.

Bevorzugte Ausführungsbeispiele der vorliegenden Erfindung werden nachfolgend mit Bezug auf die beiliegenden Figuren näher erläutert. Es zeigen:
- Fig. 1: ein schematisches Blockschaltbild eines bevorzugten Ausführungsbeispiels der vorliegenden Erfindung;
- Fig. 2: ein schematisches Blockschaltbild eines Teils des Ausführungsbeispiels aus Fig. 1;
- Fig. 3: eine schematische Darstellung der Versorgungsleistungsaufnahme des Ausführungsbeispiels aus den Fig. 1 und 2;
- Fig. 4: ein schematisches Flußdiagramm ; und
- Fig. 5: ein schematisches Schaltungsdiagramm eines herkömmlichen Klasse-E-Verstärkers.

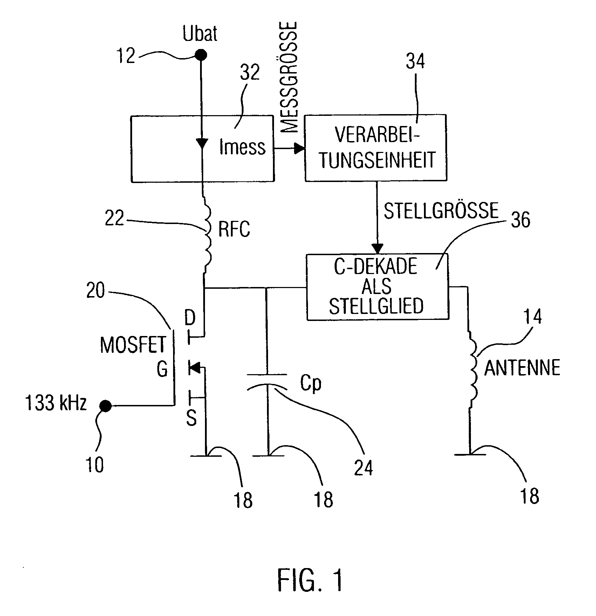

Fig. 1 ist ein schematisches Blockdiagramm eines Klasse-E-Verstärkers gemäß einem ersten Ausführungsbeispiel der vorliegenden Erfindung. Der erfindungsgemäße Klasse-E-Verstärker unterscheidet sich von dem oben anhand der Fig. 5 dargestellten herkömmlichen Klasse-E-Verstärker dadurch, daß zwischen den Versorgungsleistungseingang 12 und die Drossel 22 eine Meßeinrichtung 32 zum Messen der Versorgungsleistungsaufnahme des Verstärkers geschaltet ist, die mit einer Verarbeitungseinheit bzw. Steuereinrichtung 34 verbunden ist. Ferner weist der erfindungsgemäße Klasse-E-Verstärker anstelle des Filterkondensators 26 mit der konstanten Kapazität C_{F} eine C-Dekade bzw. Kondensatordekade 36 auf. Die Gesamtkapazität der Kondensatordekade 36 und damit die Konfiguration der aus der Antenne 14 und der Kondensatordekade 36 gebildeten Resonanzschaltung sind einstellbar.

Die Steuereinrichtung 34 empfängt von der Meßeinrichtung 32 ein Signal, das die Versorgungsleistungsaufnahme des Verstärkers über den Versorgungsleistungseingang 12 anzeigt. Die Versorgungsleistungsaufnahme des Verstärkers ist die Meßgröße bzw. Eingangsgröße der Steuereinrichtung 34. Als Maß für die Versorgungsleistungsaufnahme des Verstärkers wird der vom Versorgungsleistungseingang 12 zur Drossel 22 fließende Strom Imess genommen. Dies ist insbesondere bei einer Versorgung des Verstärkers aus einer niederohmigen Leistungsquelle bzw. Spannungsquelle sinnvoll, deren Versorgungsspannung Ubat von dem Strom Imess weitgehend unabhängig ist. Alternativ oder zusätzlich wird die Spannung des Versorgungsleistungseingangs 12 gegenüber der Masse 18 gemessen, um die genaue Versorgungsleistungsaufnahme P des Verstärkers als Produkt P = Ubat · Imess der Versorgungsspannung Ubat und des Stroms Imess zu berechnen. Die Meßeinrichtung 32 umfaßt also einen Sensor zum Erfassen des Stroms Imess oder einen Sensor zum Erfassen der Versorgungsspannung Ubat und optional zusätzlich eine Einrichtung zum Bestimmen der Versorgungsleistungsaufnahme P aus dem Produkt der Versorgungsspannung Ubat und des Stroms Imess.

Vorzugsweise wird der erfindungsgemäße Verstärker durch eine niederohmige Leistungsquelle mit Leistung versorgt, deren Versorgungsspannung Ubat im wesentlichen konstant ist. Die Meßeinrichtung 32 umfaßt deshalb vorzugsweise einen Sensor zur Bestimmung des Versorgungsstroms Imess bzw. von dessen Gleichstromanteil.

Die Steuereinrichtung 34 gibt an die Kondensatordekade 36 ein Steuersignal aus, das eine Sollgröße bzw. Stellgröße für die Gesamtkapazität der Kondensatordekade darstellt. Die Kondensatordekade 36 schaltet abhängig von dem Steuersignal von der Steuereinrichtung 34 bzw. der durch dieses dargestellten Stellgröße eine Mehrzahl von Kondensatoren parallel. Die Kondensatordekade wählt die parallel geschalteten Kondensatoren so aus, daß die Summe der Kapazitäten der parallel geschalteten Kondensatoren der Stellgröße bzw. der einzustellenden Gesamtkapazität entspricht oder am nächsten liegt.

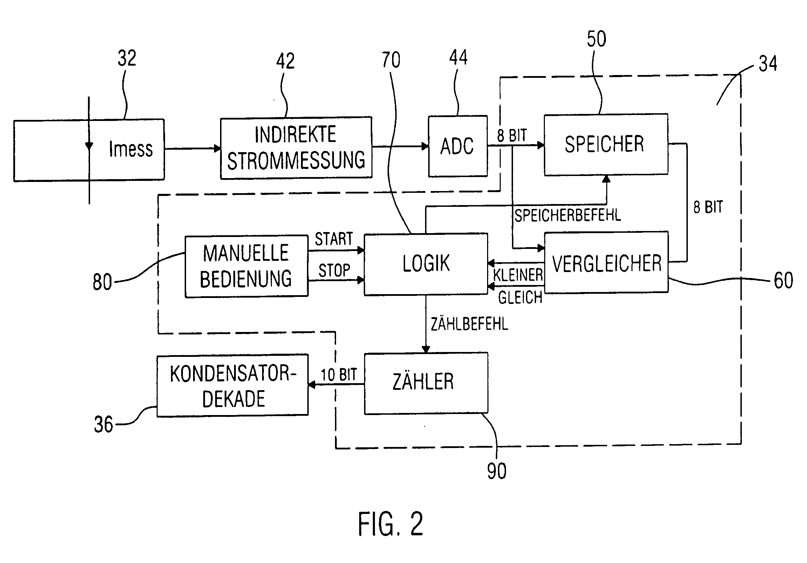

Wie im Folgenden anhand der Fig. 2 bis 4 näher beschrieben wird, steuert die Steuereinrichtung 34 die Kondensatordekade 36 so, daß nacheinander mehrere oder vorzugsweise alle durch die Kondensatordekade einstellbaren Gesamtkapazitäten eingestellt werden. Bei jeder eingestellten Gesamtkapazität mißt die Meßeinrichtung 32 die Versorgungsleistungsaufnahme des Verstärkers. Die Steuereinrichtung 34 bestimmt den Wert der Gesamtkapazität, bei dem die Versorgungsleistungsaufnahme des Verstärkers minimal ist und stellt diesen anschließend ein.

Fig. 2 ist ein schematisches Blockdiagramm, das die Meßeinrichtung 32, die Steuereinrichtung 34 und die Kondensatordekade 36 aus Fig. 1 sowie deren wichtigste Funktionsblöcke zeigt. Gemäß diesem Ausführungsbeispiel erfolgt die Messung des Versorgungsstroms Imess vorzugsweise indirekt, beispielsweise als Spannungsabfall an einem bekannten Widerstand im Strompfad. Diese Spannung an dem bekannten Widerstand oder eine andere direkte Meßgröße wird - schematisch dargestellt durch den Block 42 - verstärkt, gefiltert oder auf andere Weise aufbereitet, um ein analoges Signal zu erhalten, das die indirekte Meßgröße Imess darstellt. Dieses Signal wird einem Analog-Digital-Wandler 44 zugeführt, der das analoge Signal in ein digitales Signal wandelt. Das digitale Signal stellt die Größe, den Pegel oder eine andere Eigenschaft des analogen Signals, welche den indirekt gemessenen Versorgungsstrom Imess wiedergibt, dar. Im vorliegenden Ausführungsbeispiel erzeugt der Analog-Digital-Wandler 44 ein Datenwort mit 8 Bit, das somit 256 verschiedene Meßwerte des Versorgungsstroms Imess darstellen kann. Im einfachsten Fall sind die Meßeinrichtung 32, der Block 42 und der Analog-Digital-Wandler 44 so ausgelegt bzw. aufgebaut, daß ein (zumindest näherungsweise) linearer Zusammenhang zwischen dem Versorgungsstrom Imess und dem von dem Analog-Digital-Wandler 44 ausgegebenen digitalen Signal besteht.

Alternativ und vorzugsweise sind die Meßeinrichtung 32, der Block 42 und der Analog-Digital-Wandler 44 so ausgebildet, daß nur Versorgungsströme Imess innerhalb eines kleinen Meßwerteintervalls auf die 256 möglichen digitalen Ausgangssignale (gewöhnlich dargestellt durch die ganzen Zahlen 0, 1, 2, ..., 255) des Analog-Digital-Wandlers 44 abgebildet werden. Dieses Meßwertintervall umfaßt den minimalen Versorgungsstrom, der auftreten kann, wobei dieser minimale Versorgungsstrom vorzugsweise nahe der oder an der unteren Grenze dieses Meßwertintervalls liegt. In diesem Fall besteht anstelle eines proportionalen Zusammenhangs ein affin-linearer oder allgemeiner ein nichtlinearer Zusammenhang zwischen dem Versorgungsstrom Imess und dem digitalen Ausgangssignal des Analog-Digital-Wandlers 44 bzw. einer durch dieses darstellbaren Zahl. Durch diesen nichtlinearen Zusammenhang ist auch bei einer geringen Auflösung des Analog-Digital-Wandlers 44 eine hochgenaue Bestimmung des Versorgungsstroms mittels der vorliegenden Erfindung möglich.

In diesem Zusammenhang wird darauf hingewiesen, daß weder an die Meßeinrichtung 32 noch an den Analog-Digital-Wandler 44 oder die schematisch in dem Block 42 zusammengefaßten Elemente (Filter, Verstärker etc.) hohe Anforderungen an Linearität und Langzeitstabilität bzw. Langzeitdriftverhalten gestellt sind. Diese Elemente können deshalb einfach und mit geringem Aufwand entwickelt und hergestellt werden. Für die vorliegende Erfindung ist lediglich ein monotoner oder besser streng monotoner Zusammenhang zwischen dem Versorgungsstrom Imess und dem digitalen Ausgangssignal des Analog-Digital-Wandlers 44 erforderlich.

Die Steuereinrichtung 34 ist in Fig. 2 durch einen unterbrochen bzw. gestrichelt dargestellten Rahmen angedeutet, der eine Mehrzahl von Funktionselementen umfaßt. Alle diese Funktionselemente sind in diesem Ausführungsbeispiel digital bzw. empfangen, verarbeiten und erzeugen ausschließlich digitale Signale.

Die Steuereinrichtung 34 umfaßt einen Speicher 50, der das digitale Ausgangssignal des Analog-Digital-Wandlers 44 empfängt. Ferner umfaßt die Steuereinrichtung 34 einen Vergleicher 60, der ebenfalls das digitale Ausgangssignal des Analog-Digital-Wandlers 44 empfängt. Der Vergleicher 60 empfängt darüber hinaus ein digitales Signal vom Speicher 50, das einen in dem Speicher 50 gespeicherten Wert darstellt. Eine Logikschaltung 70 empfängt von dem Vergleicher 60 Signale, die anzeigen, ob der durch das digitale Ausgangssignal des Analog-Digital-Wandlers 44 dargestellte Wert des Stroms Imess bzw. der Versorgungsleistungsaufnahme des Verstärkers kleiner als der momentan im Speicher 50 gespeicherte Wert oder zu diesem gleich ist. Die Logik 70 steuert über einen Speicherbefehl den Speicher 50. Der Speicherbefehl steuert ein Speichern des momentanen digitalen Ausgangssignals des Analog-Digital-Wandlers 44 durch den Speicher 50. Die Logik 70 empfängt von einer Bedienungseinheit 80 zur manuellen Bedienung des Verstärkers Steuersignale, die ein Starten und ein Stoppen des nachfolgend beschriebenen erfindungsgemäßen Verfahrens steuern. Die Logikschaltung 70 erzeugt ferner einen Zählbefehl, der ein Zählen durch einen Zähler 90 steuert. Der Zähler 90 umfaßt einen Speicher, in dem eine Zahl gespeichert ist. Diese Zahl wird durch den Zähler 90 inkrementiert (oder dekrementiert), wenn der Zähler 90 den Zählbefehl von der Logikschaltung 70 empfängt. Der Zähler 90 erzeugt ein - im vorliegenden Ausführungsbeispiel 10 Bit breites - Datenwort für die Kondensatordekade 36. Dieses Datenwort stellt die durch die Kondensatordekade 36 durch Parallelschalten geeigneter Kondensatoren einzustellende Gesamtkapazität dar.

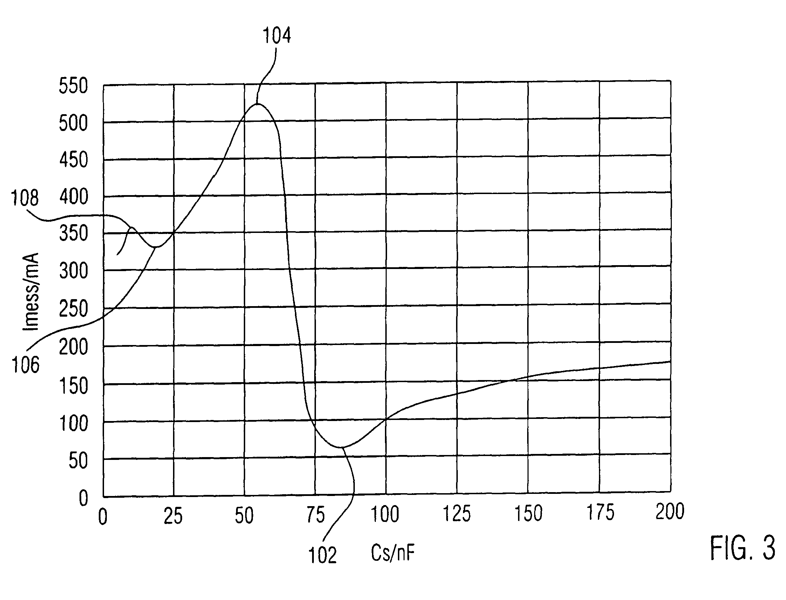

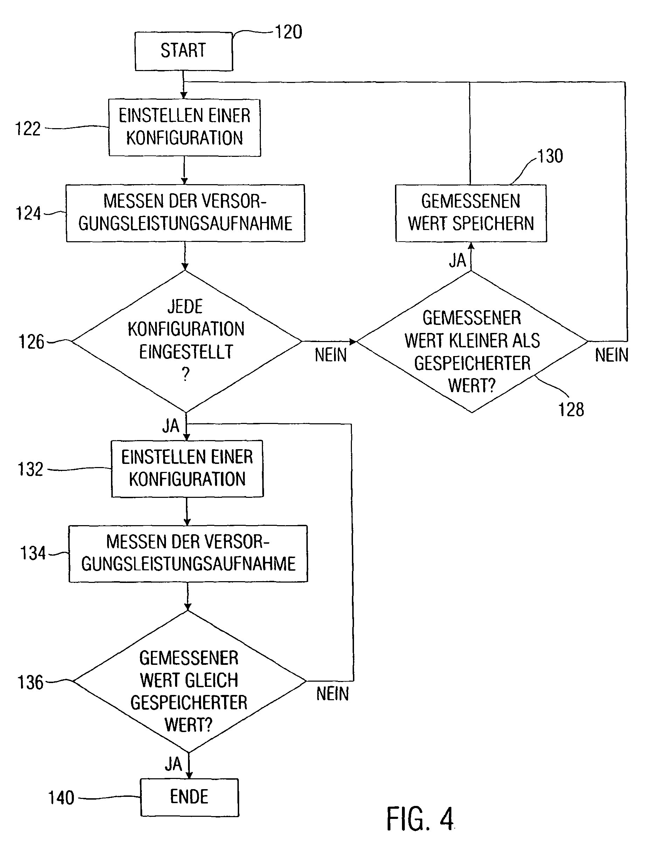

Um im Folgenden anhand der Fig. 4 die Funktion der Steuereinrichtung 34 und ihrer Funktionselemente näher beschreiben zu können, wird zunächst anhand der Fig. 3 der Zusammenhang zwischen der durch die Kondensatordekade 36 eingestellten Gesamtkapazität und dem Versorgungsstrom Imess dargestellt. Fig. 3 ist ein schematisches Diagramm, dessen Abszisse die eingestellte Kapazität Cs der Kondensatordekade 36 zugeordnet ist. Da die Kondensatordekade 36 in Reihe bzw. in Serie mit der Antenne 14 geschaltet ist, wird ihre eingestellte Gesamtkapazität Cs auch als Reihenkapazität bezeichnet. Der Ordinate ist der Versorgungsstrom Imess des Verstärkers zugeordnet.

Erkennbar weist der Versorgungsstrom Imess eine starke Abhängigkeit von der Reihenkapazität bzw. der eingestellten Gesamtkapazität Cs der Kondensatordekade 36 auf. Der Versorgungsstrom weist ein globales Minimum 102 und ein globales Maximum 104 sowie bei kleineren Reihenkapazitäten Cs ein weiteres Minimum 106 und ein weiteres Maximum 108 auf. Es fällt auf, daß der Versorgungsstrom Imess beim globalen Maximum 104 fast um eine Größenordnung größer ist als im globalen Minimum 102. Das globale Maximum 104 liegt bei einem kleineren Wert der Reihenkapazität Cs als das globale Minimum 102. Zwischen dem globalen Maximum 104 und dem globalen Minimum 102 fällt der Versorgungsstrom Imess sehr schnell um fast eine Größenordnung. Für Reihenkapazitäten, die größer als die Reihenkapazität des globalen Minimums 102 sind, steigt der Versorgungsstrom Imess wieder langsam aber kontinuierlich an. Insgesamt ist der Fig. 3 also zu entnehmen, daß der Versorgungsstrom Imess und damit die Versorgungsleistungsaufnahme des Verstärkers ein ausgeprägtes Minimum aufweisen, und daß die Versorgungsleistungsaufnahme des Verstärkers in diesem Minimum wesentlich geringer ist als für andere Werte der Reihenkapazität Cs.

Fig. 4 ist ein schematisches Flußdiagramm, das ein Verfahren darstellt. Dieses Verfahren wird insbesondere durch die Steuereinrichtung 34 automatisch ausgeführt.

Dabei werden die meisten Verfahrensschritte durch die Logikschaltung 70 gesteuert.

Das Verfahren wird durch eine manuelle Bedienung der Bedienungseinheit 80 gestartet 120. Alternativ erfolgt der Start 120 des Verfahrens durch ein Rücksetz- bzw. Reset-Signal, das dem Verstärker bzw. der Steuereinrichtung 34 und insbesondere der Logikschaltung 70 zu bestimmten Zeitpunkten bzw. bei bestimmten Ereignissen zugeführt wird. Vorzugsweise wird das Rücksetzsignal nach dem Anschalten der Versorgungsspannung Ubat, nach einem Übergang von einem Bereitschaftsbetriebsmodus zu einem aktiven Betriebsmodus oder bei ähnlichen Ereignissen erzeugt.

Nach dem Start 120 wird zunächst eine erste Konfiguration der Resonanzeinrichtung eingestellt. Die in dem Zähler 90 gespeicherte Zahl nimmt gesteuert über den Zählbefehl von der Logikschaltung 70 einen vorbestimmten Startwert an. Alternativ wird der Wert der im Zähler 90 gespeicherten Zahl eingestellt bzw. beibehalten, der bereits gespeichert ist, so daß der Startwert der momentan gespeicherte Wert ist. Der Zähler 90 gibt diese Zahl an die Kondensatordekade 36 aus. Die Kondensatordekade 36 stellt einen Wert der Reihenkapazität bzw. Gesamtkapazität ein, der dem Wert der Zahl z eindeutig zugeordnet ist. Beispielsweise ist die Gesamtkapazität Cs = 50 nF + 0,2 nF · z. Für Werte von z zwischen 0 und 255 nimmt die Gesamtkapazität Cs dann Werte zwischen 50 nF und 101 nF an.

Wenn die Konfiguration eingestellt ist 122, mißt die Meßeinrichtung 32 in einem nächsten Verfahrensschritt 124 die Versorgungsleistungsaufnahme des Verstärkers. Die Versorgungsleistungsaufnahme oder der Versorgungsstrom wird durch die Meßeinrichtung 32, wie oben beschrieben, direkt oder indirekt gemessen. Das analoge Meßsignal wird, wie in Fig. 2 durch den Block 42 angedeutet, gefiltert, verstärkt etc. und anschließend durch den Analog-Digital-Wandler 44 in ein digitales Signal gewandelt.

In einem nächsten Verfahrensschritt 126 wird festgestellt, ob bereits alle einstellbaren Konfigurationen eingestellt wurden. Dies ist beispielsweise dann der Fall, wenn die in dem Zähler 90 gespeicherte Zahl einen vorbestimmten Endwert aufweist.

Wenn noch nicht alle Konfigurationen eingestellt wurden, wird in einem Schritt 128 festgestellt, ob der gemessene Wert der Versorgungsleistungsaufnahme kleiner als der gespeicherte Wert ist. Dazu vergleicht der Vergleicher 60 das digitale Ausgangssignal des Analog-Digital-Wandlers 44 bzw. den durch das digitale Ausgangssignal dargestellten Wert der Versorgungsleistungsaufnahme des Verstärkers mit einem in dem Speicher 50 bereits gespeicherten Wert. Die Logikschaltung 70 empfängt von dem Vergleicher 60 ein Signal, das anzeigt, ob der gemessene Wert der Versorgungsleistungsaufnahme kleiner ist als der gespeicherte Wert. Ist dies der Fall, so sendet die Logikschaltung 70 einen Speicherbefehl an den Speicher 50. Ansprechend auf diesen Speicherbefehl wird in einem Schritt 130 der gemessene Wert der Versorgungsleistungsaufnahme in dem Speicher 50 gespeichert, d. h. der in dem Speicher gespeicherte Wert wird durch den gemessenen Wert der Versorgungsleistungsaufnahme ersetzt.

Unabhängig davon, ob der gemessene Wert der Versorgungsleistungsaufnahme kleiner als der gespeicherte Wert ist, kehrt das Verfahren anschließend zum Schritt 122 zurück. Die Logikschaltung 70 erzeugt einen Steuerbefehl für den Zähler 90. Gesteuert durch den Steuerbefehl inkrementiert (oder dekrementiert) der Zähler 90 die in ihm gespeicherte Zahl z. Die Kondensatordekade 36 empfängt die neue in dem Zähler 90 gespeicherte Zahl z und stellt ihre Gesamtkapazität Cs entsprechend der neuen Zahl z ein. Dies bedeutet ein Wiederholen des Schritts 122 mit einer neuen Konfiguration.

Anschließend werden die Schritte 124 des Messens und 126 des Entscheidens wiederholt.

Die Schleife aus den Schritten 122, 124, 126, 128, 130 wird so lange wiederholt, bis jede einstellbare Konfigurationen einmal eingestellt war. Wenn der Zähler 90 ausgelegt ist, um gesteuert durch den Zählbefehl von der Logikschaltung 70 die gespeicherte Zahl z zu inkrementieren, entspricht dies einer Bewegung in dem Diagramm aus Fig. 3 von dem globalen Maximum 104 zu dem globalen Minimum 102.

Sobald im Schritt 126 festgestellt wird, daß jede einstellbare Konfiguration einmal eingestellt war, verläßt das Verfahren bzw. die dieses ausführende Logikschaltung 70 die Schleife aus den Schritten 122, 124, 126, 128, 130. Der Speicher 50 enthält nun den kleinsten gemessenen Wert der Versorgungsleistungsaufnahme.

Das Verfahren geht nun zu einem Schritt 132 des Einstellens einer Konfiguration über Beim ersten ausführen des Schrittes 132 wird vorzugsweise der Zähler 90 wieder auf den vorbestimmten Startwert gesetzt. Anschließend wird in einem Schritt 134 die Versorgungsleistungsaufnahme des Verstärkers gemessen, wie dies bereits im Schritt 124 in der ersten Schleife geschah.

Der gemessene Wert der Versorgungsleistungsaufnahme wird in einem Schritt 136 durch den Vergleicher 60 mit dem im Speicher 50 gespeicherten Wert verglichen. Wenn der gemessene Wert der Versorgungsleistungsaufnahme nicht gleich dem im Speicher 50 gespeicherten Wert ist, werden die Schritte 132 des Einstellens und 134 des Messens wiederholt.

Bei jeder Wiederholung bzw. bei jedem Durchlaufen der Schleife aus den Schritten des Einstellens 132, des Messens 134 und des Entscheidens 136 wird die in dem Zähler 90 gespeicherte Zahl z im Schritt 132 inkrementiert (oder dekrementiert), und die Kondensatordekade 36 stellt eine der Zahl z entsprechende Gesamtkapazität Cs ein. Mit der Schleife aus den Schritten des Einstellens 132, des Messens 134 und des Entscheidens 136 wird somit erneut die Kurve aus Fig. 3 zwischen dem globalen Maximum 104 und dem globalen Minimum 102 durchlaufen.

Sobald bei einem Schleifendurchlauf beim Schritt 136 des Entscheidens die Logikschaltung 70 ein Signal von dem Vergleicher 60 empfängt, das anzeigt, daß der gemessene Wert der Versorgungsleistungsaufnahme gleich dem gespeicherten Wert ist, wird das Verfahren beendet, da feststeht, daß die Konfiguration der Resonanzschaltung bzw. die Gesamtkapazität Cs der Kondensatordekade 36 eingestellt ist, bei der die Versorgungsleistungsaufnahme des Verstärkers den minimalen Wert angenommen hat.

Anders ausgedrückt durchläuft der Abstimmvorgang bzw. das Verfahren zwei Phasen. In der durch die Schritte 122 des Einstellens, 124 des Messens, 126 des Entscheidens und 128 des Speicherns dargestellten ersten Phase bzw. ersten Schleife wird die minimale Versorgungsleistungsaufnahme der Verstärkung gemessen bzw. bestimmt. Dabei werden bei jedem Schritt 122 des Einstellens gesteuert durch die in dem (vorzugsweise binären) Zähler 90 gespeicherte Zahl z Kondensatoren in der Kondensatordekade 36 zu einer anderen Gesamtkapazität parallel geschaltet. Die Kapazitäten der parallel zu schaltenden Kondensatoren der Kondensatordekade sind vorzugsweise so ausgewählt, daß durch das binäre Schalten eine möglichst lineare Änderung der Kapazität bewirkt wird. Durch die in Fig. 3 erkennbare nichtlineare Änderung der Versorgungsleistungsaufnahme bei einer linearen Änderung der Gesamtkapazität Cs der Kondensatordekade 36 bietet sich als einfachster Algorithmus das beschriebene binäre Schalten der Kapazitäten an.

Beim ersten Durchlaufen der Schleife 122, 124, 126, 128 sind die eingestellte Gesamtkapazität Cs klein und damit der Versorgungsstrom Imess und die Versorgungsleistungsaufnahme des Verstärkers groß. In der ersten Tuningphase bzw. bei jedem Durchlaufen der Schleife 122, 124, 126, 128 wird der gemessene Wert der Versorgungsleistungsaufnahme durch den Vergleicher 60 mit dem im Speicher 50 gespeicherten Wert verglichen. Wenn der gemessene Wert den gespeicherten Wert unterschreitet, wird der gemessene Wert der Versorgungsleistungsaufnahme als neuer Wert in den Speicher 50 übernommen. Am Ende der ersten Tuningphase ist somit der minimale Wert der Versorgungsleistungsaufnahme in dem Speicher 50 gespeichert.

In der zweiten Tuningphase bzw. in der zweiten Schleife des Einstellens 132, des Messens 134 und des Entscheidens 136 wird der Zähler 90 bzw. die in ihm gespeicherte Zahl z zunächst auf einen Anfangswert zurückgesetzt und anschließend solange erhöht, bis der gemessene Wert der Versorgungsleistungsaufnahme den im Speicher 50 gespeicherten Wert erreicht hat. Das Autotuning ist damit beendet 140.

Das in Fig. 4 dargestellte, von der Logikschaltung 70 gesteuerte und von der Steuereinrichtung 34 ausgeführte Verfahren ist in zahlreichen Punkten variierbar. In der ersten Tuningphase, die durch die Schleife aus den Schritten des Einstellens 122, des Messens 124, des Entscheidens 126 und des Speicherns 128 gebildet wird, wird vorzugsweise von der kleinsten in dem Zähler 90 speicherbaren Zahl z ausgegangen. Diese kleinste im Zähler 90 speicherbare Zahl wird beim Start 120 in den Zähler geladen bzw. der Zähler 90 wird auf diesen Startwert zurückgesetzt. Bei jedem Durchlaufen des Schritts 122 des Einstellens einer Konfiguration wird die Zahl z um 1 erhöht bzw. inkrementiert. Alternativ wird bei Beginn der ersten Tuningphase die im Zähler 90 gespeicherte Zahl z auf ihren maximalen Wert gesetzt. Bei jedem Durchlaufen des Schritts des Einstellens 122 wird die Zahl z um 1 verringert bzw. dekrementiert.

Wenn die Versorgungsleistungsaufnahme eine glatte Funktion der eingestellten Gesamtkapazität Cs ist und zumindest innerhalb des Intervalls der durch die Kondensatordekade 36 einstellbaren Werte der Gesamtkapazität Cs keine lokalen Minima aufweist, bei denen die Versorgungsleistungsaufnahme größer als im globalen Minimum 102 ist, ist das anhand der Fig. 4 dargestellte Verfahren abkürzbar. Dabei wird eine Schleife aus den Schritten 122, 124, 128, 130 nur so lange durchlaufen, wie der gemessene Wert der Versorgungsleistungsaufnahme kleiner als der gespeicherte Wert ist. Sobald der gemessene Wert der Versorgungsleistungsaufnahme gleich dem gespeicherten Wert oder größer als dieser ist, steht unter der genannten Bedingung fest, daß das globale Minimum erreicht oder überschritten ist. Daraufhin verläßt das Verfahren die Schleife und geht zu dem Schritt 132 des Einstellens über.

Ein Vorteil dieser abgekürzten Variante besteht in der Zeitersparnis, die daraus resultiert, daß bei Erreichen (oder Überschreiten) des Minimums die erste Tuningphase abgebrochen wird. En Vorteil des oben dargestellten vollständigen Durchlaufens aller möglichen Werte der Zahl z und damit des gesamten Intervalls der durch die Kondensatordekade 36 einstellbaren Gesamtkapazität Cs hat hingegen den Vorteil, daß das Verfahren auch im Falle des Vorliegens lokaler Minima der Versorgungsleistungsaufnahme nicht zufällig an einem lokalen Minimum abbricht, ohne das globale Minimum gefunden zu haben.

Auch die zweite Tuningphase, die durch die Schleife aus den Schritten des Einstellens 132, des Messens 134 und des Entscheidens 136 gebildet wird, beginnt vorzugsweise mit einem definierten Startwert der im Zähler 90 gespeicherten Zahl. Alternativ beginnt die zweite Tuningphase bei einem beliebigen Startwert der im Zähler 90 gespeicherten Zahl, von dem ausgehend die Zahl z bei jedem Durchlaufen der Schleife 132, 134, 136 inkrementiert oder dekrementiert wird.

Vorzugsweise werden in das anhand der Fig. 4 dargestellte Verfahren zusätzliche Schritte eingebaut, um die Stabilität des Verfahrens gegenüber (statistischen) Fluktuationen des Meßwerts der Versorgungsleistungsaufnahme zu verbessern. Aufgrund einer statistischen Fluktuation ist es beispielsweise möglich, daß das oben anhand der Fig. 4 dargestellte Verfahren in der zweiten Tuningphase nie mehr die minimale Versorgungsleistungsaufnahme mißt, die in der ersten Tuningphase im Speicher 50 gespeichert wurde. Um trotzdem einen Abbruch des Verfahrens herbeizuführen, wird die zweite Tuningphase bzw. die Schleife 132, 134, 136 so umgestaltet, daß sie bei einem ersten Durchlaufen aller möglichen Werte der im Zähler 90 gespeicherten Zahl und der durch die Kondensatordekade 36 eingestellten Gesamtkapazität Cs abbricht, wenn der gemessene Wert der Versorgungsleistungsaufnahme gleich dem gespeicherten Wert ist. Wenn dies aufgrund einer statistischen Meßwertfluktuation in einem ersten Versuch bei keiner der möglichen Zahlen z der Fall ist, wird die Abbruchbedingung in einem zweiten Versuch abgeschwächt, indem beispielsweise der in dem Speicher 50 gespeicherte Wert um 1 erhöht wird.

Vorzugsweise ist das Verfahren ferner so ausgebildet, daß zuverlässig das globale Minimum 102 gefunden wird, und auch ein Rauschen bzw. eine statistische Fluktuation des Meßsignals zufällig erzeugte lokale Minima nicht zu einem Abbruch des Verfahrens führen.

Wie bereits oben erwähnt, wird das Verfahren entweder durch ein an der Bedienungseinheit 80 durch manuelle Bedienung erzeugtes Startsignal gestartet. Alternativ wird das Verfahren durch ein eigenes Startsignal oder ein auch für andere Bauelemente erzeugtes Rücksetzsignal gestartet. Ein solches Start- oder Rücksetzsignal wird beispielsweise durch einen Steuercomputer bei oder nach jeder Änderung der Eingangsfrequenz des am Signaleingang 10 anliegenden Eingangssignals bereitgestellt, um das Verfahren zu starten. Dazu ist anstelle der Bedienungseinheit 80 eine Schnittstelle zu einem Steuercomputer, zu einem Systembus oder ähnlichem vorgesehen.

In Fig. 4 ist erkennbar, daß die zweite Tuningphase mit den Schritten des Einstellens 132, des Messens 134 und des Entscheidens 136 eine ganz ähnliche logische Struktur bzw. eine ganz ähnliche Schleife aufweist wie die erste Tuningphase mit den Schritten des Einstellens 122, des Messens 124, des Entscheidens 126 und des Speicherns 128. Um Speicherplatz zu sparen, sind deshalb beide Schleifen vorzugsweise durch die gleichen Software- oder Firmwarestrukturen realisiert. Ein Steuerparameter kann zwei Werte annehmen. Ein erster Wert des Steuerparameters zeigt an, daß die erste Tuningphase vorliegt. In diesem Fall wird die Schleife solange durchlaufen, wie der gemessene Wert der Versorgungsleistungsaufnahme kleiner als der gespeicherte Wert ist, wobei der gemessene kleinere Wert jeweils in den Speicher 50 übernommen wird. Ein zweiter Wert des Steuerparameters zeigt an, daß die zweite Tuningphase vorliegt. In diesem Fall werden der im Speicher 50 gespeicherte Wert nicht mehr verändert und die Schleife solange ausgeführt, bis der gemessene Wert der Versorgungsleistungsaufnahme gleich dem gespeicherten Wert ist.

Das Verfahren und jede der beschriebenen Varianten sind auch in Form eines Computer-Programms mit Programmcode zur Durchführung des oben beschriebenen Verfahrens, wenn das Programm auf einem Computer abläuft, implementierbar.

Ferner sind zahlreiche Modifikationen des oben anhand der Fig. 1 und 2 dargestellten bevorzugten Ausführungsbeispiels des erfindungsgemäßen Verstärkers möglich und vorteilhaft. Abweichend von den Angaben in Fig. 2 können sowohl der Speicher 50 als auch der Zähler 90 in Anpassung an die Anforderungen an Genauigkeit, Schaltungsaufwand, Geschwindigkeit des Verfahrens sowie an die genaue Abhängigkeit der Versorgungsleistungsaufnahme von der eingestellten Gesamtkapazität Cs der Kondensatordekade 36 größere oder kleinere Datenworte verarbeitet werden. Je genauer der Analog-Digital-Wandler 44 arbeitet und je mehr binäre Stellen das von ihm erzeugte und vom Speicher 50 gespeicherte Datenwort umfaßt, desto genauer kann das Minimum 102 erreicht werden. Eine geringere Genauigkeit des Analog-Digital-Wandlers 44 und eine entsprechend geringere Anzahl der durch den Speicher 50 gespeicherten binären Stellen hat andererseits eine höhere Wandlungsgeschwindigkeit des Analog-Digital-Wandlers 44 und einen geringeren Leistungsbedarf des Analog-Digital-Wandlers 44, des Speichers 50 und des Vergleichers 60 sowie einen geringeren Platzbedarf derselben zur Folge.

Der in Fig. 2 dargestellte Zähler 90 und die Kondensatordekade 36 weisen einen Umfang von 10 Bit auf, d. h. die im Zähler 90 gespeicherte Zahl z nimmt Werte zwischen 0 und 1.023 an, und die Kondensatordekade 36 umfaßt zehn Kondensatoren, deren Kapazitäten sich wie 1:2:4:8:...:512 verhalten. Eine weitere Vergrößerung des Zählers 90 und der Kondensatordekade 36 auf 11, 12 oder mehr Bit bringt eine weitere Steigerung der Genauigkeit. Eine Verkleinerung des Zählers 90 und der Kondensatordekade 36 auf 9, 8 oder weniger Bit führt z einer Verringerung von Flächenbedarf und Strombedarf derselben und zu einer Beschleunigung des erfindungsgemäßen Verfahrens.

Um sowohl bei dem Analog-Digital-Wandler 44, dem Speicher 50 und dem Vergleicher 60 als auch bei der Kondensatordekade 36 und dem Zähler 90 einen möglichst geringen Flächen- und Leistungsbedarf mit einer möglichst hohen Genauigkeit zu vereinbaren, wird, wie oben bereits mit Bezug auf den Analog-Digital-Wandler 44 beschrieben, vorzugsweise eine nichtlineare Abbildung der Versorgungsleistung auf die digitalen Ausgangssignale des Analog-Digital-Wandlers 44 und eine nichtlineare Abbildung der im Zähler 90 gespeicherten Zahl z auf die Gesamtkapazität Cs der Kondensatordekade 36 implementiert. Beispielsweise werden im Zähler 90 gespeicherte Zahlen z zwischen 0 und 1.023 auf Gesamtkapazitäten Cs der Kondensatordekade 36 zwischen 70 nF und 100 nF abgebildet, indem ein Kondensator mit einer Kapazität von 70 nF ständig parallel geschaltet wird. Gleichzeitig werden Versorgungsströme zwischen 60 mA und 100 mA auf digitale Signale bzw. durch den Speicher 50 zu speichernde Zahlen zwischen 0 und 255 abgebildet, indem vor der Analog-Digital-Wandlung ein entsprechender Offset-Strom von dem Versorgungsstrom Imess analog abgezogen wird.

Alternativ zu der oben anhand der Fig. 1, 2 und 4 dargestellten digitalen Implementierung wird die vorliegende Erfindung durch eine analoge Schaltung implementiert. Anstelle der Kondensatordekade tritt in diesem Fall vorzugsweise eine Varaktordiode oder ein anderes Kapazitätsbauelement mit einer analog steuerbaren Kapazität. Ferner wird alternativ anstelle der Kapazität der Kapazitätsdekade die Induktivität eines Induktivitätsbauelements eingestellt, um die Konfiguration der Resonanzschaltung und damit den Resonanzpunkt des Verstärkers zu verändern.

Als Resonanzschaltung, deren Konfiguration gemäß der vorliegenden Erfindung eingestellt wird, wurde oben die Reihenschaltung aus der Antenne 14 und der Kondensatordekade 36 bezeichnet. Zur Resonanzschaltung können jedoch auch der Parallelkondensator 24 und die Drossel 22 hinzugezählt werden, da sie ebenfalls Einfluß auf den Resonanzpunkt des Verstärkers haben. Auch die (frequenzabhängigen) Eigenschaften des MOSFET 20 beeinflussen den Resonanzpunkt des Verstärkers. Dies ändert jedoch nichts an der Wirksamkeit der vorliegenden Erfindung, bei dem die Konfiguration eines als Resonanzschaltung bezeichneten, das Hochfrequenzverhalten und die Versorgungsleistungsaufnahme des Verstärkers wesentlich beeinflussende Teil des Verstärkers so eingestellt wird, daß die Versorgungsleistungsaufnahme des Verstärkers minimal ist.

Die oben anhand der Figuren dargestellten Ausführungsbeispiele beziehen sich vorzugsweise auf einen Klasse-E-Verstärker, sind jedoch ohne weiteres auch auf andere Verstärker und Verstärker anderer Klassen anwendbar, bei denen die Versorgungsleistungsaufnahme von einer Konfiguration einer Resonanzschaltung bzw. einer Schaltung mit frequenzabhängigen Eigenschaften abhängt.

## Patentansprüche

1. Verstärker mit:
einem aktiven Bauelement (20);
einer Resonanzschaltung (14, 36) mit einer Mehrzahl von einstellbaren Konfigurationen;
einer Einstelleinrichtung (36) zum Einstellen von einer der Mehrzahl von Konfigurationen der Resonanzschaltung;
einer Meßeinrichtung (32) zum Messen einer Versorgungsleistungsaufnahme des Verstärkers; und
einer Steuereinrichtung (34) zum Steuern der Einstelleinrichtung (36) und zum Auslesen der Meßeinrichtung (32) derart, daß die Einstelleinrichtung (36) nacheinander eine Mehrzahl von Konfigurationen einstellt und die Meßeinrichtung (32) für jede der Mehrzahl von Konfigurationen die Versorgungsleistungsaufnahme des Verstärkers mißt, wobei die Steuereinrichtung (34) ferner ausgebildet, um eine optimale Konfiguration aus der Mehrzahl von Konfigurationen zu bestimmen, bei der die Versorgungsleistungsaufnahme minimal ist, und um die Einstelleinrichtung (36) zu steuern, um die Resonanzschaltung gemäß der optimalen Konfiguration einzustellen.

2. Verstärker nach Anspruch 1, wobei der Verstärker ein Klasse-E-Verstärker ist, wobei das aktive Bauelement (20) einen ersten Anschluß (S), einen zweiten Anschluß (D) und einen Steueranschluß (G) umfaßt, wobei die Resonanzschaltung mit dem zweiten Anschluß (D) verbunden ist, an dem die Versorgungsleistung anliegt.

3. Verstärker nach Anspruch 1 oder 2, bei dem die Resonanzschaltung ein Kapazitätsbauelement (36) mit einer Kapazität und ein Induktivitätsbauelement (14) mit einer Induktivität umfaßt, wobei die Einstelleinrichtung eine Einrichtung zum Einstellen der Kapazität des Kapazitätsbauelements (36) oder eine Einrichtung zum Einstellen der Induktivität des Induktivitätsbauelements umfaßt.

4. Verstärker nach Anspruch 3, bei dem das Kapazitätsbauelement (36) eine Mehrzahl von Kondensatoren umfaßt, die einzeln schaltbar parallelschaltbar sind.

5. Verstärker nach einem der Ansprüche 1 bis 4, bei dem die Steuereinrichtung (34) folgende Merkmale umfaßt:
einen Speicher (50) zum Speichern eines Werts der Versorgungsleistungsaufnahme;
einen Vergleicher (60) zum Vergleichen eines von der Meßeinrichtung gemessenen Werts der Versorgungsleistungsaufnahme mit einem in dem Speicher (50) gespeicherten Wert; und
eine Einrichtung (70) zum Speichern des gemessenen Werts der Versorgungsleistungsaufnahme in dem Speicher (50), wenn der gemessene Wert kleiner als der gespeicherte Wert ist.

## Claims

1. Amplifier comprising:
an active device (20);
a resonant circuit (14, 36) having a plurality of settable configurations;
a setting means (36) for setting one of the plurality of configurations of the resonant circuit;
a measuring means (32) for measuring a supply power consumption of the amplifier; and
a control means (34) for controlling the setting means (36) and for reading out the measuring means (32) such that the setting means (36) successively sets a plurality of configurations, and the measuring means (32) measures the supply power consumption of the amplifier for each of the plurality of configurations, the control means (34) further being configured to determine, from the plurality of configurations, an optimum configuration wherein the supply power consumption is minimal, and to control the setting means (36) to set the resonant circuit in accordance with the optimum configuration.

2. Amplifier as claimed in claim 1, the amplifier being a class E amplifier, the active device (20) including a first terminal (S), a second terminal (D) and a control terminal (G), the resonant circuit being connected to the second terminal (D) at which the supply power is applied.

3. Amplifier as claimed in claim 1 or 2, wherein the resonant circuit includes a capacitance device (36) having a capacitance, and an inductance device (14) having an inductance, the setting means comprising a means for setting the capacitance of the capacitance device (36), or a means for setting the inductance of the inductance device.

4. Amplifier as claimed in claim 3, wherein the capacitance device (36) comprises a plurality of capacitors which may be individually connected in parallel.

5. Amplifier as claimed in any of claims 1 to 4, wherein the control means (34) comprises:
a memory (50) for storing a value of the supply power consumption;
a comparator (60) for comparing a value, measured by the measuring means, of the supply power consumption, to a value stored in the memory (50); and
a means (70) for storing the measured value of the supply power consumption-in the memory (50) if the value measured is smaller than the value stored.

## Revendications

1. Amplificateur avec :
un composant actif (20) ;
un circuit résonant (14, 36) avec une pluralité de configurations réglables ;
un dispositif de réglage (36) destiné à régler l'une de la pluralité de configurations du circuit résonant ;
un dispositif de mesure (32) destiné à mesurer une consommation de puissance d'alimentation de l'amplificateur ; et
un dispositif de commande (34) destiné à commander le dispositif de réglage (36) et à lire le dispositif de mesure (32) de sorte que le dispositif de réglage (36) règle successivement une pluralité de configurations et que le dispositif de mesure (32) mesure, pour chacune de la pluralité de configurations, la consommation de puissance d'alimentation de l'amplificateur, le dispositif de commande (34) étant, par ailleurs, réalisé de manière à déterminer une configuration optimale parmi la pluralité de configurations dans laquelle la consommation de puissance d'alimentation est minimale, et de manière à commander le dispositif de réglage (36) pour régler le circuit résonant selon la configuration optimale.

2. Amplificateur selon la revendication 1, dans lequel l'amplificateur est un amplificateur de classe E, le composant actif (20) comportant une première connexion (S), une deuxième connexion (D) et une connexion de commande (G), le circuit résonant étant relié à la deuxième connexion (D) à laquelle est présente la puissance d'alimentation.

3. Amplificateur selon la revendication 1 ou 2, dans lequel le circuit résonant comporte un composant de capacité (36) avec une capacité et un composant d'inductance (14) avec une inductance, le dispositif de réglage comportant un dispositif destiné à régler la capacité du composant de capacité (36) ou un dispositif destiné à régler l'inductance du composant d'inductance.

4. Amplificateur selon la revendication 3, dans lequel le composant de capacité (36) comporte une pluralité de condensateurs qui peuvent être commutés individuellement en parallèle.

5. Amplificateur selon l'une des revendications 1 à 4, dans lequel le dispositif de commande (34) comprend les caractéristiques suivantes:
une mémoire (50) destinée à mémoriser une valeur de consommation de puissance d'alimentation ;
un comparateur (60) destiné à comparer une valeur de consommation de puissance d'alimentation mesurée par le dispositif de mesure à une valeur mémorisée dans la mémoire (50) ; et
un dispositif (70) destiné à mémoriser la valeur de consommation de puissance d'alimentation mesurée dans la mémoire (50) lorsque la valeur mesurée est inférieure à la valeur mémorisée.
